Europäisches Patentamt

European Patent Office

Office européen des brevets

(11) Veröffentlichungsnummer: **0 029 876**

**A1**

## (12) EUROPÄISCHE PATENTANMELDUNG

(21) Anmeldenummer: **80104030.4**

(51) Int. Cl.³: **H 03 H 1/00**

(22) Anmeldetag: **12.07.80**

(30) Priorität: **30.11.79 DE 2948217**

(43) Veröffentlichungstag der Anmeldung:
**10.06.81 Patentblatt 81/23**

(84) Benannte Vertragsstaaten:
**AT BE CH FR GB IT LI NL**

(71) Anmelder: **Licentia Patent-Verwaltungs-GmbH
Theodor-Stern-Kai 1
D-6000 Frankfurt/Main 70(DE)**

(72) Erfinder: **Pivit, Erich, Dr.-Ing.
Akazienhain 14
D-7151 Allmersbach i.T.(DE)**

(74) Vertreter: **Schickle, Gerhard, Dipl.-Ing. et al,
Licentia Patent-Verwaltungs-GmbH Theodor-Stern-Kai 1
D-6000 Frankfurt/Main 70(DE)**

(54) Filteranordnung zur Dämpfung von kurzen Störwellen.

(57) Filteranordnung zur Dämpfung von kurzen Störwellen hoher Energie (EMP), bestehend aus einem in eine dämpfende Masse (Abs) hoher Permeabilität eingebetteten Leiter (1) und einem sie umgebenden Blechgehäuse (BG) und ist dadurch gekennzeichnet, dass die eine grosse Dielektrizitätskonstante und einen niedrigen spezifischen Widerstand aufweisende Masse (Abs) den Leiter (1) kontaktiert und an ihrem äusseren Umfange an eine auf der Innenseite des Blechgehäuses angebrachte Isolierschicht (Is) angrenzt.

Fig. 1

EP 0 029 876 A1

- 1 -

Licentia Patent-Verwaltungs-GmbH          NE2-BK/Ruf/jo
Theodor-Stern-Kai 1                       BK 79/99
D-6000 Frankfurt 70

Filteranordnung zur Dämpfung von kurzen Störwellen

Die Erfindung betrifft eine Filteranordnung zur Dämpfung von
kurzen Störwellen hoher Energie (EMP).

Bekannte Filter dieser Art bestehen üblicherweise aus konzentrierten Bauelementen, beispielsweise aus der Hintereinanderschaltung von T- oder Pi-Gliedern mit Induktivitäten
im Längs- und Kondensatoren im Querzweig. Solche Filter weisen zwar einen sehr steilen Anstieg des Dämpfungsverlaufs
über der Frequenz auf, erleiden jedoch bei höheren Frequenzen Dämpfungseinbrüche aufgrund parasitärer Elemente wie
Parallelkapazitäten der Induktivitäten und Längsinduktivitäten der Querkondensatoren. Diese üblichen Filteranordnungen sind deshalb bei Netzanschlüssen nur als Oberwellenfilter einsetzbar und wenig oder gar nicht als Filter zur Unterdrückung der HF-Energie geeignet, die aufgrund des verzögerten Zündens der Überspannungsableiter bei EM-Impulsen
(beispielsweise entstehend durch Blitznaheinschläge) mit
hoher Flankensteilheit zum Transformator des Netzanschaltgeräts durchgelassen wird. Erreicht die HF- Energie die nachgeschalteten Einrichtungen ungedämpft, so kann großer Schaden hervorgerufen werden. Insbesondere bei Betriebsstätten mit schutzisoliertem Netzanschluß, bei denen mit einem Versagen nicht gerechnet wird, ist eine entsprechende Dämpfung der HF-Energie auf kleine, ungefährliche Werte erforderlich.

Aufgabe der Erfindung war es deshalb, ein breitbandiges, wenig aufwendiges Dämpfungsfilter mit Tiefpaßcharakteristik zur Dämpfung von kurzen Störwellen hoher Energie anzugeben, mit dem EM-Impulse von einer Dauer $\leq$ 1 µsec und mit einer Amplitude von bis zu ungefähr 10 kV auf ungefährliche Werte gedämpft werden, wobei der Sperrbereich dieses Tiefpasses etwa von < 1 MHz bis in den GHz-Bereich reichen soll.

Die Lösung erfolgt mit den in den Patentansprüchen angegebenen Mitteln.

Aus der DE-PS 25 26 127 ist es bekannt, sehr kurze Störwellen eines Hochfrequenz-Kreises mit Hilfe eines Elements aus einem elektrisch nicht leitenden und mit magnetischen Verlusten behafteten Materials zu dämpfen. Hierbei handelt es sich um eine Einrichtung, bei der in einer speziellen Weise Oberflächenströme einer leitenden Wand eines Hochfrequenzkreises gedämpft werden.

Weiterhin ist aus "Electronics World", Band 81 Nr. 4, April 1969, Seite 55, eine Dämpfungseinrichtung bekannt geworden, die aus Ferritperlen besteht, welche einzeln oder zu mehreren auf einen stromführenden Leiter aufgefädelt werden. Mit dieser Dämpfungseinrichtung lassen sich die hohen Frequenzen eines Rauschstromes oder Mikrowellen bedämpfen, wobei das Dämpfungsprinzip jedoch auf Impedanzvergrößerung, d.h. auf Reflexion und nicht auf Absorption von HF-Energie basiert.

Weiterhin ist durch die DE-PS 872 593 eine Entstördrossel zur Dämpfung von Störwellen mit einer in Eisenkrernmasse eingebetteten Wicklung und einem sie umgebenden Blechgehäuse bekannt geworden, bei der zwischen Kernmasse und Blechgehäuse ein Mantel aus magnetisch weichem Material mit hoher Anfangspermeabilität und hohem spezifischem Widerstand angeordnet ist. Dieser Anordnung ist ebenfalls das Prinzip der Impedanzvergrößerung für die Störwellen zugrundegelegt, wobei versucht wird, zu verhindern, daß das Blechgehäuse als eine Kurschlußwindung und somit induktivitätsmindernd wirkt.

In der DE-AS 25 24 300 wird ein Mikrowellenabsorber in einem Koaxial-Leitungsabschnitt beschrieben, bei dem das Dämpfungsmaterial aus einem Gemisch eines Ferritpulvers mit einer hochmolekularen organischen Verbindung besteht und bei dem je nach Frequenz bestimmte, ausgesiebte und zusammen mit den organischen Bindern erhitzte Ferritkörnungen verwendet werden.

Durch die erfindungsgemäße Filteranordnung wird es in unaufwendiger Art ermöglicht, daß kurze Störwellenimpulse, beispielsweise < 1 μsec. hoher Energie (EMP), beispielsweise bis Größenordnung 10 kV, in dem breitbandigen Spektrum ab etwa 1 MHz oder darunter bis in den GHz-Bereich auf unschädliche Werte gedämpft werden.

Es folgt nun eine Beschreibung anhand der Figuren.

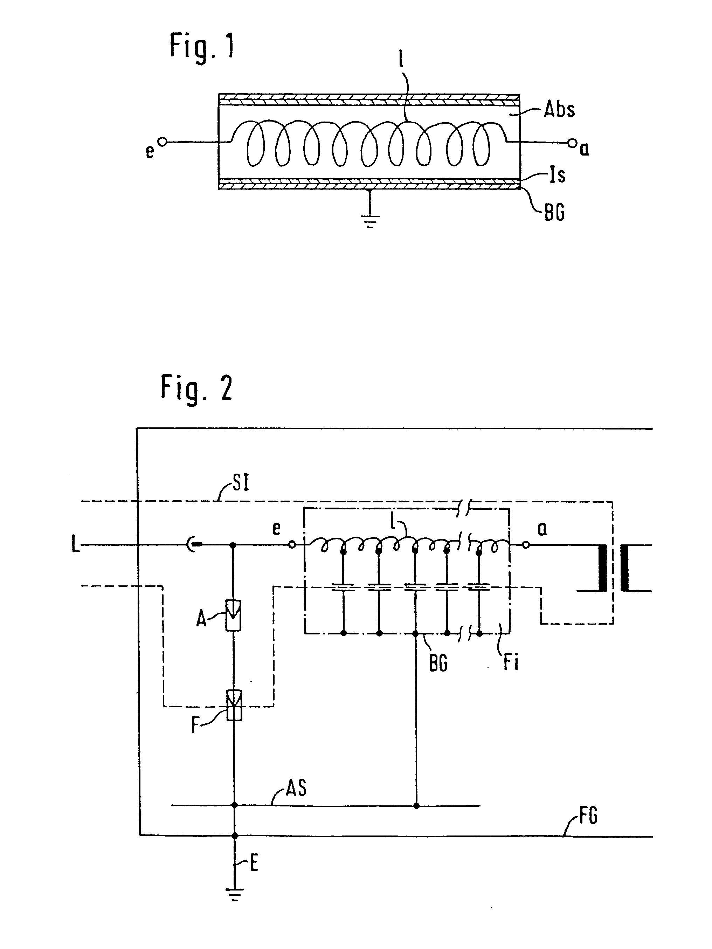

Die Fig. 1 zeigt eine Ausgestaltung des erfindungsgemässen Filters, wobei ein rohrförmiges geerdetes Blechgehäuse BG, das innen mit einer Isolationsschicht Is beschichtet ist, mit Absorptionsmaterial Abs ausgefüllt ist, in den konzentrisch ein gewendelter Leiter 1 mit
Eingang e auf der einen Seite des Rohres und Ausgang a
auf der anderen Seite des Rohrers eingebettet ist. Das
Absorptionsmaterial besteht aus verlustbehaftetem magnetischem bzw. dielektrischem Material, beispielsweise
aus dem Gemisch Karbonyleisen, Ferritpulver, grobes
Eisenpulver, Graphit usw. Vorteilhafterweise werden
die pulverförmigen Absorptionsmittel mittels geeigneter Bindemittel, beispielsweise Epoxidharz gebunden.
Auch in den bzw. um den Leiter eingelegtes bzw. gepacktes Dynamoblech ergibt gute Dämpfungseigenschaften.

Die Fig. 2 stellt ein Einsatzbeispiel der erfindungsgemäßen Filteranordnung dar, wobei eine beispielsweise
transportable elektrische Betriebsstätte über ein Netzkabel, das stromführende Leiter L, einen Nulleiter N
und evtl. Schutzerde PE enthält, mit einem Netz verbunden wird.

Die elektrische Betriebsstätte ist durch das Fahrzeuggehäuse
FG, das mit Erde E verbunden ist, angedeutet. Von dem Netz
ist stellvertretend ein stromführender Leiter L gezeichnet,
der über einen Stecker über hier nicht gezeichnete Schalter
und Sicherungen mit einem Trenntransformator eines Netzanschaltgerätes der Betriebsstätte verbindbar ist.

Am Netzeingang, direkt hinter dem Stecker, ist ein Querzweig
zu einer mit dem Fahrzeuggehäuse FG verbundenen Ausgleichsschiene AS angeordnet, der aus der Hintereinanderschaltung
eines ersten Überspannungsableiters A, der den Netzfolgestrom zu löschen vermag, und eines zweiten Überspannungsableiters F besteht, wobei die Isolierung des ersten bzw.

zweiten Überspannungsableiters in ungezündetem Zustand den
Anforderungen der Betriebsisolierung bzw. der zusätzlichen
Isolierung bei Schutzisolierung entspricht und wobei durch
beide Ableiter die bei direktem Blitzeinschlag oder nuklearen
elektromagnetischen Pulsen (NEMP) auftretenden Ströme ohne
Funktionsbeeinträchtigung abführbar sind. Ein solchermaßen
ausgerüsteter Netzanschluß mit Überspannungsableitern zum
Schutz einer elektrischen Betriebsstätte vor Überspannungen,
wie er in der Anmeldung P 29 34 235 näher beschrieben ist,
hat jedoch den Nachteil, daß EMP hoher Flankensteilheit aufgrund der Trägheit der Überspannungsableiter nicht sofort zur
Erde abgeleitet werden, sondern mit ihrer Stoßwellenfront auf
den Natzanschluß oder andere Einrichtungen der Betriebsstätte
einwirken und mehr oder weniger große Schäden oder Gefahr für
das Betriebspersonal hervorrufen können. Ein in den Längszweig hinter dem Netzanschlußstecker eingefügtes erfindungsgemäßes Filter Fi sorgt nun für die Unterdrückung etwaiger
die Überspannungsableiter passierender HF-Energie.

Die erfindungsgemäße Filteranordnung Fi ist in der Fig. 2 ersatzschaltbildmäßig durch die Hintereinanderschaltung von
T-Gliedern, die aus Induktivitäten im Längszweig (Leiter 11)
und aus Kapazitäten im zum über die Ausgleichsschiene AS geerdeten Blechgehäuse BG führenden Querzweig besteht, angedeutet. Bei diesem Ersatzschaltbild ist jedoch das verlustbehaftete Absorptionsmaterial der Übersichtlichkeit wegen nicht
berücksichtigt, was durch die jeweilige Reihenschaltung eines
Induktivitäts- und Kapazitätselements mit einem Ohmschen Widerstandselement in den T-Gliedern darzustellen wäre. Die
Schutzisolierung SI) des Netzanschlusses nach Fig. 2 (dort
gestrichelt dargestellt) muß durch den Isolationswert der
Isolierschicht Is zwischen Dämpfungsmasse und Blechgehäuse
aufgebracht werden.

Eine nach den erfindungsgemäßen Gesichtspunkten realisierte Filteranordnung, die folgende Dimensionierung aufweist:

Blechgehäuse: Länge 150 mm, Innendurchmesser 35 mm;

Leiter: Wendeldurchmesser 20 mm, Windungszahl 40, Querschnitt 6 mm² (Anschlußwert ca. 5 kW)

erbrachte einen ab etwa 1 MHz mit steigender Frequenz stetig verlaufenden Dämpfungsanstieg mit einem Dämpfungswert von etwa 40 dB bei 1 GHz.

- 1 -

Licentia Patent-Verwaltungs-GmbH
Theodor-Stern-Kai
D-6000 Frankfurt 70

NE2-BK/Ruf/jo
BK 79/99

Patentansprüche

1. Filteranordnung zur Dämpfung von kurzen Störwellen hoher
   Energie (EMP), bestehend aus einem in eine dämpfende Masse hoher Permeabilität eingebetteten Leiter und einem sie
   umgebenden Blechgehäuse, dadurch gekennzeichnet, daß die
   eine große Dielektrizitätskonstante und einen niedrigen
   spezifischen Widerstand aufweisende Masse (Abs) den Leiter (1) kontaktiert und an ihrem äußeren Umfange an eine
   auf der Innenseite des Blechgehäuses (BG) angebrachte
   Isolierschicht (Is) angrenzt.

2. Filteranordnung nach Anspruch 1, dadurch gekennzeichnet,
   daß die Masse (Abs) aus folgendem Gemisch besteht:
       etwa 1/2 Anteil grobes Eisenpulver (etwa 0,2 mm Körnung)
       etwa 1/4 Anteil Carbonyleisen (etwa 10 µm Körnung) und
       etwa 1/4 Anteil Graphit.

3. Filteranordnung nach Anspruch 1 oder 2, dadurch gekennzeichnet, daß der Leiter (1) gewendelt ist.

4. Filteranordnung nach Anspruch 2 oder 3, <u>dadurch gekenn-
zeichnet</u>, daß das Blechgehäuse (BG) ein Hohl-Zylinder
oder -Prisma ist.

5. Filteranordnung nach einer der Ansprüche 2 bis 4, <u>dadurch
gekennzeichnet</u>, daß das Blechgehäuse (BG) aus magnetisch
leitendem Material, beispielsweise Eisen oder Stahl, besteht.

6. Filteranordnung nach einem der Ansprüche 3 bis 5, <u>dadurch
gekennzeichnet</u>, daß Wendeldurchmesser zu Innendurchmesser
bzw. zu Länge des Blechgehäuses (BG) sich etwa verhalten
wie < 3/4 : 1 : 4.

7. Filteranordnung nach einem der Ansprüche 1 bis 6, <u>gekenn-
zeichnet durch</u> die Verwendung in einem Netzanschluß mit
Überspannungsableitern (A, F) zum Schutz einer elektrischen Betriebsstätte vor Überspannungen.

8. Filteranordnung nach Anspruch 7, <u>dadurch gekennzeichnet</u>,
daß die Isolierung der Isolierschicht (Is) den Anforderungen der Betriebsisolation und der zusätzlichen Isolierung bei Schutzisolierung (SI) entspricht.

9. Filteranordnung nach Anspruch 1 bis 8, <u>dadurch gekennzeich-
net</u>, daß benachbarte Windungen der Wendel mindestens einen
Abstand des Radius des Leiters (1) aufweisen.

Fig. 1

Fig. 2

## EUROPÄISCHER RECHERCHENBERICHT

Europäisches
Patentamt

| | EINSCHLÄGIGE DOKUMENTE | | KLASSIFIKATION DER ANMELDUNG (Int Cl³) |
|---|---|---|---|
| Kategorie | Kennzeichnung des Dokuments mit Angabe, soweit erforderlich, der maßgeblichen Teile | betrifft Anspruch | |
| X | CH - A - 377 888 (E. BELLAMY McMILLAN)<br>* Das ganze Dokument * | 1-6,9 | H 03 H 1/00 |
| X | DE - C - 889 765 (R. BOSCH)<br>* Das ganze Dokument * | 1-5 | |
| X | CH - A - 231 984 (R. BOSCH)<br>* Das ganze Dokument * | 1-5 | RECHERCHIERTE SACHGEBIETE (Int Cl³) |
| | FR - A - 1 490 488 (F. MAYER)<br>* Das ganze Dokument * | 1-5 | H 03 H 1/00 |
| DA | DE - C - 872 593 (R. BOSCH)<br>* Das ganze Dokument * | 1 | |

-----

Der vorliegende Recherchenbericht wurde für alle Patentansprüche erstellt.

| Recherchenort | Abschlußdatum der Recherche | Prüfer |
|---|---|---|
| Den Haag | 06-03-1981 | DECONINCK |

EPA form 1503.1 06.78